# EUROPÄISCHE PATENTANMELDUNG

(11) **EP 0 881 870 A1**
(43) Veröffentlichungstag der Anmeldung: **02.12.1998**
(21) Anmeldenummer: 98105063.6
(22) Anmeldetag: 20.03.1998
(51) Int. Cl.: H05K 7/20, H01L 23/34

(54) **Übertemperaturschutzeinrichtung**

(30) Priorität: 30.05.1997 DE 19722589
(71) Anmelder: ABB PATENT GmbH, 68309 Mannheim (DE)
(72) Erfinder: Bolduan, Peter, 58515 Lüdenscheid (DE)
(74) Vertreter: Rupprecht, Klaus, Dipl.-Ing.

(57) **Zusammenfassung**

Die Erfindung bezieht sich auf eine Vorrichtung zum Übertemperaturschutz der Umgebung eines oder mehrerer mit Anschlußbeinen (3, 4, 5) ausgestatteten Leistungstransistoren (1), die auf einer Leiterplatte (9) angeordnet sind, wobei ein Thermoschalter (6) zur Schutzabschaltung eingesetzt ist. Zur Beschleunigung des Abschaltverhaltens ist eine elektrisch isolierende, aber wärmeleitende Platte (2) auf der Unterseite der Leiterplatte (9) angeordnet und an Lötpunkten (7) mit jeweils einem Anschlußbein (3, 4,5) eines Transistors (1) verlötet. Der Thermoschalter (6) ist auf der Platte (2) montiert.

## Beschreibung

Die Erfindung bezieht sich auf eine Schutzeinrichtung, die die Umgebung eines Leistungstransistors im Fall seines Defekts vor den Wirkungen einer Übertemperatur schützt.

Die Erfindung kann insbesondere in Dimmern zur Steuerung der Helligkeit von Beleuchtungseinrichtungen, aber auch in anderen, einen oder mehrere Leistungstransistoren aufweisenden Geräten angewendet werden, in denen solche Transistoren auf einer Leiterplatte montiert sind.

Üblicherweise wird in solchen Geräten die in den Leistungstransistoren entstehende Verlustwärme mittels Kühlblechen abgeführt, um eine bestimmte Umgebungstemperatur für benachbarte Komponenten, insbesondere für die Leiterplatte nicht zu überschreiten. Im Fall eines Transistordefekts kann dessen Innenwiderstand statt weniger als 1 Ohm auch mehrere Ohm annehmen. Die dadurch erheblich gesteigerte Verlustwärme kann nicht schnell genug über Kühlbleche abgeführt werden, wodurch die Temperatur in der unmittelbaren Umgebung des Leistungstransistors unzulässig hohe Werte annehmen kann.

Zur Vermeidung einer unzulässigen Übertemperatur ist es üblich, in solchen Geräten einen oder mehrere Thermoschalter anzuordnen, die je nach elektrischer Schaltung jeweils den Laststromkreis unterbrechen, oder den Transistor überbrükken. Ein solcher Thermoschalter wird üblicherweise auf ein Kühlblech oder an das Gehäuse des Transistors montiert.

Es hat sich gezeigt, daß im Fall eines Transistordefekts zuerst dessen Anschlußbeine sehr heiß werden und erst mit zeitlicher Verzögerung das Kühlblech oder das Gehäuse eine so hohe Temperatur annehmen, daß der Thermoschalter auslöst. Dadurch kann es bis zur Abschaltung durch einen Thermoschalter bereits zu Schäden in der Umgebung des Leistungstransistors, insbesondere an der Leiterplatte, gekommen sein.

Der Erfindung liegt daher die Aufgabe zugrunde, eine ausreichend schnell wirkende Einrichtung zum Schutz der Umgebung eines Leistungstransistors vor Übertemperatur im Fall eines Transistordefekts anzugeben. Sie soll außerdem weitestgehend unabhängig von der Art der Kühlung der Transistoren sein.

Diese Aufgabe wird durch eine Vorrichtung zum Schutz der Umgebung eines oder mehrerer mit Anschlußbeinen ausgestatteten Leistungstransistoren gegen Übertemperatur gelöst, die die im Anspruch 1 angegebenen Merkmale aufweist.

Die Vorrichtung hat den Vorteil, daß im wesentlichen nur ein zusätzliches, besonders einfaches und robustes Bauteil, nämlich eine wärmeleitende Platte, benötigt wird, die praktisch ohne besonderen Platzbedarf in ein Gerät einsetzbar ist.

Eine weitere Beschreibung der Schutzvorrichtung erfolgt nachstehend anhand eines in der Zeichnungsfigur dargestellten Ausführungsbeispiels.

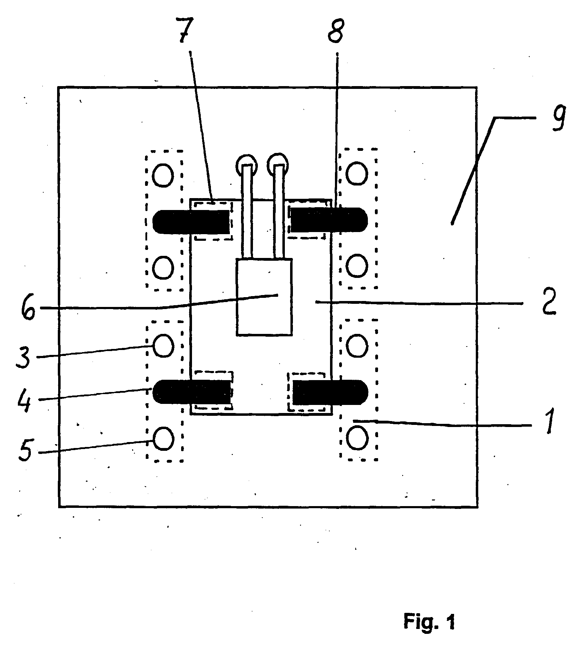

Fig. 1 zeigt eine Ansicht der Unterseite einer Leiterplatte 9, die auf ihrer Oberseite Leistungstransistoren 1 oder andere Leitungshalbleiterbauelemente trägt. Die Transistoren 1 haben Anschlußbeine 3, 4, 5, die durch Bohrungen der Leiterplatte 9 hindurchragen. Die Transistoren 1 können Kühlbleche tragen, die in der Ansicht auf die Leiterplattenunterseite nicht sichtbar sind. Die vier Transistoren 1 des Ausführungsbeispiels sind in zwei beabstandeten Reihen angeordnet. Dazwischen ist eine elektrisch isolierende, aber thermisch gut leitende Platte 2, z.B. eine Keramikplatte aus Aluminiumoxid angeordnet. Die Platte 2 ist mit Lötpunkten 7 versehen, an denen sie lötfähig ist. Jeder Transistor 1 ist mit wenigstens einem Anschlußbein 3, 4, 5 mit einem Lötpunkt 7 mittels einer Lötverbindung 8 verbunden. Zur Herstellung der Lötverbindung 8 kann das jeweilige Anschlußbein umgebogen und mittels Weichlot am Lötpunkt 7 mit der Platte 2 verbunden sein.

Im Ausführungsbeispiel ist ein Thermoschalter 6 auf die Unterseite der Platte 2 mit gutem thermischem Kontakt montiert. Der Thermoschalter 6 könnte aber auch zwischen der Leiterplatte 9 und der Platte 2 angeordnet sein.

Der Thermoschalter 6 ist üblicherweise so in eine elektrische Schaltung eingefügt, daß er den oder die Laststromkreise unterbricht.

## Patentansprüche

1. Vorrichtung zum Übertemperaturschutz der Umgebung wenigstens eines mit Anschlußbeinen (3,4,5) ausgestatteten Leistungstransistors (1) mittels wenigstens eines Thermoschalters (6), wobei der wenigstens eine Transistor (1) auf einer Leiterplatte (11) angeordnet ist, auf deren Unterseite die Transistoranschlußbeine (3,4,5) herausragen, dadurch gekennzeichnet, daß
a) auf der Leiterplattenunterseite eine elektrisch isolierende und wärmeleitende Platte (2) angeordnet ist, die Lötpunkte (7) aufweist,
b) an den Lötpunkten (7) jeweils eine Lötverbindung (8) zwischen der wärmeleitenden Platte (2) und einem Transistoranschlußbein (3,4,5) besteht, und
c) der Thermoschalter (6) entweder zwischen der Leiterplatte (9) und der wärmeleitenden Platte (2) angeordnet und auf der Oberseite der wärmeleitenden Platte (2) diese gut wärmeleitend kontaktierend montiert ist, oder auf der Unterseite der wärmeleitenden Platte diese gut wärmeleitend kontaktierend montiert ist.

2. Vorrichtung nach Anspruch 1, dadurch gekennzeichnet, daß die wärmeleitende Platte (2) eine Keramikplatte ist.

3. Vorrichtung nach Anspruch 1 oder 2, dadurch gekennzeichnet, daß sie in einem Dimmer zur Helligkeitssteuerung einer Beleuchtungseinrichtung angeordnet ist.
